(19) Europäisches Patentamt
European Patent Office
Office européen des brevets

(11) **EP 4 279 936 B1**

(12) **EUROPÄISCHE PATENTSCHRIFT**

(45) Veröffentlichungstag und Bekanntmachung des Hinweises auf die Patenterteilung:
**24.12.2025 Patentblatt 2025/52**

(21) Anmeldenummer: **23168856.5**

(22) Anmeldetag: **20.04.2023**

(51) Internationale Patentklassifikation (IPC):
**G01R 31/392** *(2019.01)* **B60L 58/10** *(2019.01)*
**G01R 31/396** *(2019.01)*

(52) Gemeinsame Patentklassifikation (CPC):
**G01R 31/396; B60L 3/0046; B60L 58/12;
B60L 58/18; G01R 31/392;** B60L 2240/547

(54) **VERFAHREN UND VORRICHTUNG ZUR FEHLERÜBERWACHUNG EINES BATTERIEPACKS MIT MEHREREN BATTERIEZELLEN**

METHOD AND APPARATUS FOR MONITORING FAULTS IN A BATTERY PACK INCLUDING A PLURALITY OF BATTERY CELLS

PROCÉDÉ ET APPAREIL DE SURVEILLANCE DE DÉFAILLANCE DE BLOC-BATTERIE COMPRENANT UNE PLURALITÉ DE CELLULES DE BATTERIE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **17.05.2022 DE 102022204894**

(43) Veröffentlichungstag der Anmeldung:
**22.11.2023 Patentblatt 2023/47**

(73) Patentinhaber: **Volkswagen Aktiengesellschaft
38440 Wolfsburg (DE)**

(72) Erfinder: **Soundararajan, Naveen Kumar
38106 Braunschweig (DE)**

(56) Entgegenhaltungen:
DE-A1- 102020 130 547       US-A1- 2014 278 167
US-A1- 2020 249 279       US-A1- 2020 363 478
US-A1- 2020 408 849

## Beschreibung

Die Erfindung betrifft ein Verfahren und eine Vorrichtung zur Fehlerüberwachung eines Batteriepacks mit mehreren Batteriezellen.

Bei Elektrofahrzeugen und Hybridfahrzeugen ist eine Sicherheit von in den Fahrzeugen verbauten elektrochemischen Batterien sicherzustellen. Insbesondere gilt es, im Falle einer Fehlfunktion in einer von mehreren Batteriezellen der Batterie eine thermische Ausbreitung (engl. thermal propagation) und Brände zu vermeiden. Mechanische Gegenmaßnahmen tragen zwar dazu bei, einen Ausbruch eines Feuers für begrenzte Zeit einzudämmen, aber sie verhindern nicht Kollateralschäden, die ein Batteriebrand verursacht. Daher sind Vorbeugungs- und Prognoseverfahren zur Verhinderung von Batteriebränden entwickelt worden.

Die meisten Vorhersageverfahren benötigen zusätzliche Sensoren (Drucksensoren, Dehnungsmessstreifen, Ultraschallsensoren, Gassensoren usw.) und hängen von der Korrelation zwischen gemessenen Sensorparametern wie Spannung, Strom und Temperatur der Batterien ab. Die Korrelationen zwischen Batteriegrößen, die aus den gemessenen Sensorwerten abgeleitet werden, wie ein Ladezustand (SOC), ein Gesundheitszustand (SOH) und ein Innenwiderstand, werden im Allgemeinen zusätzlich verwendet, um eine Vorhersage zu erleichtern.

Aus der CN 106707180 A ist ein Fehlererkennungsverfahren für parallele Batteriepacks bekannt. Der SOE-Durchschnittswert jedes Batteriepacks wird durch Messen von Wärme und elektrischer Energie der Batteriepacks ermittelt, der Differenzwert zwischen jedem Batteriepack und dem SOE-Durchschnittswert wird verglichen, und der Fehlerzustand der Batteriepacks wird basierend auf der Differenz beurteilt. Die SOE-Werte der Batteriepacks werden berechnet, und die Batteriepacks mit anormaler Energiefreisetzung in den mehreren Batteriepacks werden basierend auf einem Vergleich mit dem gesamten durchschnittlichen SOE-Wert entdeckt, sodass eine Fehlererkennung der anormalen Batteriepacks, der fehlerhaften Batterie, realisiert werden kann.

Die US 2020 / 0 249 279 A1 beschreibt ein Verfahren zur Diagnose von Batteriepackfehlern. Das Verfahren umfasst den Anschluss eines Diagnoseservicetools (DST) an den Batteriepack und das Messen von Batterieparametern mithilfe eines oder mehrerer elektrischer Sensoren, einschließlich der Spannung jeder Zelle/Zellgruppe. Das Verfahren umfasst das Berechnen eines abschnittsdurchschnittlichen Ladezustands (SOC) jedes Batterieabschnitts über das DST unter Verwendung der Batterieparameter und das Identifizieren einer Zelle aus den Zellen/Zellengruppen jedes jeweiligen Abschnitts mit dem niedrigsten Zellen-SOC. Für jeden jeweiligen Batterieabschnitt wird ein $\Delta$SOC-Wert als Differenz zwischen dem Abschnittsdurchschnitt und dem niedrigsten Zellen-SOC berechnet, einschließlich des Vergleichs des $\Delta$SOC-Werts für jeden Abschnitt mit einem kalibrierten Schwellenwert. Als Reaktion darauf, dass der $\Delta$SOC-Wert für einen oder mehrere Abschnitte den kalibrierten Schwellenwert überschreitet, wird über das DST eine Reparaturaktion in Bezug auf den Batteriesatz ausgeführt oder eingeleitet.

Die US 2020 / 0 408 849 A1 beschreibt ein Batteriepack. Das Batteriepack umfasst eine Vielzahl von Batteriezellen und ein BMS zum Steuern des Batteriepacks. Das BMS umfasst ein Ladezustands-(SOC)-Berechnungsmodul zum Berechnen eines SOC für jede der mehreren im Batteriepack enthaltenen Batteriezellen und eine Einheit zum Erkennen mindestens einer fehlerhaften Batteriezelle auf Grundlage des berechneten SOC jeder der mehreren Batteriezellen.

Die DE 10 2020 130 547 A1 beschreibt ein Leistungssteuersystem, das zum Austauschen von elektrischer Leistung mit einer Batteriepackung konfiguriert ist, und das umfasst: eine Leistungsumwandlungsvorrichtung; und eine Steuereinheit, wobei die Batteriepackung konfiguriert ist zum Ausgeben einer Variation eines Ladezustandswerts zwischen Zellen an die Steuereinheit, wobei die Variation basierend auf zumindest einem von einem Detektionsergebnis von einem Spannungssensor oder einem Detektionsergebnis von einem Stromsensor bestimmt ist, und die Steuereinheit konfiguriert ist zum Steuern der Leistungsumwandlungsvorrichtung derart, dass ein maximaler Ladezustandswert unter einer Vielzahl von Ladezustandswerten der Zellen niedriger ist als eine Obergrenze eines vorbestimmten Ladezustandsbereichs und ein minimaler Ladezustandswert unter den Ladezustandswerten der Zellen höher ist als eine Untergrenze des vorbestimmten Ladezustandsbereichs, wobei der maximale Ladezustandswert und der minimale Ladezustandswert Werte basierend auf der Variation sind.

Die US 2014 / 0 278 167 A1 beschreibt adaptive Schätztechniken zur Erstellung eines Batteriezustandsschätzers zur Schätzung der Leistungsfähigkeit des Batteriepakets in einem Fahrzeug. Der Schätzer aktualisiert adaptiv die Parameter des Schaltungsmodells, die zur Berechnung der Spannungszustände des ECM eines Batteriesatzes verwendet werden. Die adaptiven Schätztechniken können auch zur Berechnung von Festkörperdiffusionsspannungseffekten innerhalb des Batteriepakets verwendet werden. Der adaptive Schätzer wird verwendet, um die Robustheit der Berechnung gegenüber Sensorrauschen, Modellierungsfehlern und Verschlechterung des Batteriepakets zu erhöhen.

Der Erfindung liegt die Aufgabe zu Grunde, ein Verfahren und eine Vorrichtung zur Fehlerüberwachung eines Batteriepacks mit mehreren Batteriezellen zu verbessern.

Die Aufgabe wird erfindungsgemäß durch ein Verfahren mit den Merkmalen des Patentanspruchs 1 und eine Vorrichtung mit den Merkmalen des Patentanspruchs 8 gelöst. Vorteilhafte Ausgestaltungen der Erfindung ergeben sich aus den Unteransprüchen.

Insbesondere wird ein Verfahren zur Fehlerüberwachung eines Batteriepacks mit mehreren Batteriezellen zur Verfügung gestellt, wobei Leerlaufspannungen umfassende Zustandsgrößen der Batteriezellen bestimmt oder empfangen werden, wobei anhand der bestimmten oder empfangenen Leerlaufspannungen die Batteriezelle mit der kleinsten Leerlaufspannung als schwächste Batteriezelle identifiziert wird, und wobei jeweils für jede der Batteriezellen mindestens eine Leistungsgröße des Batteriepacks ausgehend von den bestimmten oder empfangenen Zustandsgrößen der Batteriezelle bestimmt wird, und wobei die mindestens eine Leistungsgröße des Batteriepacks, die ausgehend von den Zustandsgrößen der schwächsten Batteriezelle bestimmt wurde, mit einem Mittelwert der mindestens einen Leistungsgröße verglichen wird, der aus den Leistungsgrößen des Batteriepacks bestimmt wurde, die ausgehend von den Zustandsgrößen der restlichen Batteriezellen bestimmt wurden, und wobei ein Fehlerzustand ausgehend von einem Vergleichsergebnis bestimmt und bereitgestellt wird.

Ferner wird insbesondere eine Vorrichtung zur Fehlerüberwachung eines Batteriepacks mit mehreren Batteriezellen geschaffen, umfassend eine Datenverarbeitungseinrichtung, wobei die Datenverarbeitungseinrichtung dazu eingerichtet ist, Leerlaufspannungen umfassende Zustandsgrößen der Batteriezellen zu empfangen, anhand der empfangenen Leerlaufspannungen die Batteriezelle mit der kleinsten Leerlaufspannung als schwächste Batteriezelle zu identifizieren, und jeweils für jede der Batteriezellen mindestens eine Leistungsgröße des Batteriepacks ausgehend von den empfangenen Zustandsgrößen der Batteriezelle zu bestimmen, die mindestens eine Leistungsgröße des Batteriepacks, die ausgehend von den Zustandsgrößen der schwächsten Batteriezelle bestimmt wurde, mit einem Mittelwert der mindestens einen Leistungsgröße zu vergleichen, der aus den Leistungsgrößen des Batteriepacks bestimmt wurde, die ausgehend von den Zustandsgrößen der restlichen Batteriezellen bestimmt wurden, und einen Fehlerzustand ausgehend von einem Vergleichsergebnis zu bestimmen und bereitzustellen.

Das Verfahren und die Vorrichtung ermöglichen es, zuverlässig einen Fehlerzustand des Batteriepacks zu bestimmen. Dem liegt der Gedanke zugrunde, dass die schwächste Batteriezelle des Batteriepacks die Leistungsfähigkeit des gesamten Batteriepacks bestimmt und das Auftreten eines Fehlers bei der schwächsten Batteriezelle am wahrscheinlichsten ist. Daher wird die schwächste Batteriezelle des Batteriepacks über die Leerlaufspannungen der Batteriezellen identifiziert. Insbesondere ist die schwächste Batteriezelle hierbei diejenige Batteriezelle, die die kleinste Leerlaufspannung aufweist. Haben mehrere Batteriezellen die gleiche (kleinste) Leerlaufspannung, so wird das Verfahren jeweils entsprechend für alle diese Batteriezellen durchgeführt. Für jede der Batteriezellen wird ferner mindestens eine Leistungsgröße des Batteriepacks ausgehend von den bestimmten oder empfangenen Zustandsgrößen der Batteriezelle bestimmt. Anders ausgedrückt wird die mindestens eine Leistungsgröße für das gesamte Batteriepack ausgehend von den Zustandsgrößen einer einzelnen Batteriezelle des Batteriepacks bestimmt, wobei dies für jede der Batteriezellen in dem Batteriepack erfolgt, sodass insgesamt eine der Anzahl der Batteriezellen im Batteriepack entsprechende Anzahl von Werten der mindestens einen Leistungsgröße des Batteriepacks bestimmt wird. Die mindestens eine Leistungsgröße des Batteriepacks, die ausgehend von den Zustandsgrößen der schwächsten Batteriezelle bestimmt wurde, wird mit einem Mittelwert der mindestens einen Leistungsgröße verglichen, der aus den Leistungsgrößen des Batteriepacks bestimmt wurde, die jeweils ausgehend von den Zustandsgrößen der restlichen Batteriezellen bestimmt wurden. Anders ausgedrückt wird insbesondere ein Zustand der schwächsten Batteriezelle mit einem (gemittelten) Zustand der restlichen Batteriezellen des Batteriepacks verglichen. Ausgehend von einem Vergleichsergebnis wird ein Fehlerzustand bestimmt und bereitgestellt.

Ein Vorteil des Verfahrens und der Vorrichtung ist, dass das Verfahren und die Vorrichtung den Fehlerzustand sehr robust bestimmen können. Insbesondere eine fehlerhafte Änderung des Fehlerzustands (z.B. von "fehlerfrei" zu "fehlerhaft"; d.h. eine "false positive"-Entscheidung) kann hierdurch vermieden werden, sodass bei einer Anwendung in Fahrzeugen insbesondere ungerechtfertigte Werkstattaufenthalte und Stilllegungen verbessert verhindert werden können. Im Gegensatz hierzu ist ein SOC-/Leerlaufspannungsverhalten, wie dieses im Stand der Technik ausgewertet wird, nicht-linear über die SOC-Arbeitskurve, sodass Vergleiche zwischen Batteriezellen zu einer nicht robusten Fehlererkennung führen.

Zustandsgrößen umfassen insbesondere die Leerlaufspannung und einen (aktuellen) SOC-Wert der jeweiligen Batteriezelle.

Ein State of Charge (SOC)-Wert bezeichnet insbesondere einen Ladezustand einer Batteriezelle oder eines Batteriepacks. Die Einheit des SOC-Wertes ist insbesondere Prozent (%). Der SOC-Wert gibt den Ladezustand insbesondere in Bezug auf einen maximal möglichen Ladezustand an (nachfolgend auch als $SOC_{max}$ bezeichnet). Ferner kann auch ein minimaler Ladezustand definiert sein, bis zu dem eine Entladung erfolgen kann, beispielsweise weil eine Tiefenentladung verhindert werden soll (nachfolgend auch als $SOC_{min}$ bezeichnet).

Ein State of Health (SOH)-Wert bezeichnet insbesondere einen Gesundheitszustand einer Batteriezelle oder eines Batteriepacks. Der Gesundheitszustand ist hierbei insbesondere eine Kennzahl, die den (Alterungs-)Zustand der Batteriezelle oder des Batteriepacks mit Bezug auf einen idealen Zustand beschreibt. Typischerweise weist eine Batterie bei der Herstellung einen SOH-Wert von 100 % (oder 1) auf. Mit zunehmender Betriebsdauer nimmt dieser Wert ab und vermindert die Leistungsfähigkeit, das heißt, insbesondere reduziert sich eine Ladungsmenge, die in der Batteriezelle bzw. dem Batteriepack gespeichert werden kann.

Ein State of Energy (SOE)-Wert bezeichnet insbesondere einen Energiezustand einer Batteriezelle oder eines Batteriepacks. Die Einheit des SOE-Wertes ist insbesondere Prozent (%). Der SOE-Wert gibt den Energiezustand insbesondere in Bezug auf einen maximal möglichen Energiezustand an (nachfolgend auch als $SOE_{max}$ bezeichnet).

Teile der Vorrichtung, insbesondere die Datenverarbeitungseinrichtung, können einzeln oder zusammengefasst als eine Kombination von Hardware und Software ausgebildet sein, beispielsweise als Programmcode, der auf einem Mikrocontroller oder Mikroprozessor ausgeführt wird. Es kann jedoch auch vorgesehen sein, dass Teile einzeln oder zusammengefasst als anwendungsspezifische integrierte Schaltung (ASIC) und/oder feldprogrammierbares Gatterfeld (FPGA) ausgebildet sind.

In einer Ausführungsform ist vorgesehen, dass im Rahmen des Vergleichs eine Differenz zwischen der mindestens einen Leistungsgröße des Batteriepacks, die ausgehend von den Zustandsgrößen der schwächsten Batteriezelle bestimmt wurde, und dem bestimmten Mittelwert bestimmt und mit mindestens einem vorgegebenen Fehlerschwellwert verglichen wird, und wobei der Fehlerzustand geändert wird, wenn der mindestens eine vorgegebene Fehlerschwellwert überschritten ist. Hierdurch kann direkt eine Fehlerschwelle definiert werden, ab der ein fehlerhafter Zustand festgestellt wird. Über den mindestens einen vorgegebenen Fehlerschwellwert kann eine Empfindlichkeit des Verfahrens eingestellt werden. Mehrere Fehlerschwellwerte erlauben darüber hinaus eine abgestufte Diagnose, durch die sich beispielsweise eine vorausschauende Wartungsstrategie umsetzen lässt.

In einer Ausführungsform ist vorgesehen, dass in Abhängigkeit von einem Überschreiten des mindestens einen Fehlerschwellwertes mindestens eine jeweils dem Fehlerschwellwert zugeordnete Aktion ausgeführt und/oder veranlasst wird. Hierdurch können je nach Größe einer Abweichung der mindestens einen Leistungsgröße vom Mittelwert abgestufte Maßnahmen durchgeführt werden. Beispielsweise können zwei Fehlerschwellwerte vorgesehen sein. Nach Überschreiten des ersten (niedrigeren) Fehlerschwellwertes kann beispielsweise eine Warnmeldung ausgegeben werden, welche einen Werkstattbesuch zur Abklärung und Wartung empfiehlt. Bei Überschreiten eines zweiten (größeren) Fehlerschwellwertes kann hingegen vorgesehen sein, dass ein Betrieb des Batteriepacks unterbunden wird.

In einer Ausführungsform ist vorgesehen, dass die mindestens eine Leistungsgröße des Batteriepacks einen SOE-Wert des Batteriepacks umfasst. Hierdurch kann insbesondere eine bereits aus mehreren Zustandsgrößen zusammengesetzte Größe zur Fehlerüberwachung verwendet werden. Hierdurch ist die Fehlerüberwachung robuster.

In einer weiterbildenden Ausführungsform ist vorgesehen, dass der SOE-Wert jeweils ausgehend von einer bestimmten Restenergiemenge der Batteriezellen und einer Maximalenergiemenge der Batteriezellen bestimmt wird. Hierbei ist insbesondere vorgesehen, dass der SOE-Wert ausgehend von einer Restenergiemenge und einer Maximalenergiemenge der Batteriezellen und einer nominellen Leerlaufspannung der Batteriezellen des Batteriepacks bestimmt wird. Dies wird nachfolgend beispielhaft erläutert:

Der SOE-Wert (mit der Einheit Prozent) des Batteriepacks zu einem Zeitpunkt t kann wie folgt berechnet werden:

$$SOE(t) = \frac{E_R(t)}{E_{max}} \cdot 100\%$$

mit

$$E_R(t) = Q_{SOH} V_{nom} \Delta SOC$$

und

$$E_{max} = Q_{SOH} V_{nom} SOC_{max}$$

wobei $E_R$ die Restenergiemenge (in Wh) der betrachteten Batteriezelle, $E_{max}$ die Maximalenergiemenge (in Wh) der betrachteten Batteriezelle, $Q_{SOH}$ eine gesundheitszustandsabhängige Ladungskapazität (Kapazität in Ah x SOH) der betrachteten Batteriezelle, $V_{nom}$ eine Nominalspannung der Batteriezellen in dem Batteriepack, $\Delta SOC$ eine Differenz (in Prozent) zwischen dem aktuellen Zeitpunkt und einem kleinstmöglichen Ladezustand der betrachteten Batteriezelle ($\Delta SOC = SOC(t) - SOC_{min}$, mit insbesondere $SOC_{min} = 0\%$) sind.

In einer Ausführungsform ist vorgesehen, dass die mindestens eine Leistungsgröße des Batteriepacks eine Restreichweite umfasst, wobei die Restreichweite ausgehend von einer jeweils bestimmten Restenergiemenge des Batteriepacks und einem Verbrauchsparameter bestimmt wird. Die Restreichweite wird ausgehend von den Werten einer jeweiligen Batteriezelle wie voranstehend bereits beschrieben berechnet:

$$E_R(t) = Q_{SOH} V_{nom} \Delta SOC$$

Um die Restreichweite des Batteriepacks zu bestimmen, wird der jeweilige Wert mit einer Anzahl n von Batteriezellen in dem Batteriepack multipliziert:

$$E_{R,Pack}(t) = n \cdot E_R(t)$$

Die Restreichweite R (in km) lässt sich dann mit Hilfe des Verbrauchsparameters *u* (eines Fahrzeugs, in Wh bzw. kWh/km) wie folgt bestimmen:

$$R(t) = \frac{E_{R,Pack}(t)}{u}$$

In einer Ausführungsform ist vorgesehen, dass zusätzlich die bestimmten Leerlaufspannungen mit mindestens einem vorgegebenen Leerlaufspannungsschwellwert verglichen werden, wobei der Fehlerzustand zusätzlich auch unter Berücksichtigung von einem Vergleichsergebnis des Vergleichs der Leerlaufspannungen mit dem mindestens einen vorgegebenen Leerlaufspannungsschwellwert bestimmt und bereitgestellt wird. Hierdurch können auch die Leerlaufspannungen mit bei der Fehlerüberwachung berücksichtigt werden. Es kann hierbei vorgesehen sein, dass eine Gewichtung und/oder logische Verknüpfung der Vergleichsergebnisse erfolgt.

In einer Ausführungsform ist vorgesehen, dass ausgehend von einer zeitlichen Entwicklung der mindestens einen Leistungsgröße ein zukünftiger Wert der mindestens einen Leistungsgröße geschätzt wird und das Vergleichen für den geschätzten zukünftigen Wert durchgeführt wird. Hierdurch kann einen vorausschauende Wartungsstrategie umgesetzt werden. Überschreitet der geschätzte zukünftige Wert der mindestens einen Leistungsgröße beispielswiese den mindestens einen Fehlerschwellwert, so kann eine Warnmeldung oder eine Aufforderung zur Wartung des Batteriepacks bereits frühzeitig ausgegeben werden.

Weitere Merkmale zur Ausgestaltung der Vorrichtung ergeben sich aus der Beschreibung von Ausgestaltungen des Verfahrens. Die Vorteile der Vorrichtung sind hierbei jeweils die gleichen wie bei den Ausgestaltungen des Verfahrens.

Ferner wird insbesondere auch ein Batteriepack geschaffen, umfassend mindestens eine Vorrichtung nach einer der beschriebenen Ausführungsformen.

Weiter wird insbesondere auch ein Fahrzeug geschaffen, umfassend mindestens eine Vorrichtung nach einer der beschriebenen Ausführungsformen und/oder mindestens ein Batteriepack nach einer der beschriebenen Ausführungsformen.

Nachfolgend wird die Erfindung anhand bevorzugter Ausführungsbeispiele unter Bezugnahme auf die Figuren näher erläutert. Hierbei zeigen:

Fig. 1    eine schematische Darstellung einer Ausführungsform der Vorrichtung zur Fehlerüberwachung eines Batteriepacks mit mehreren Batteriezellen;

Fig. 2    ein schematisches Ablaufdiagramm einer Ausführungsform des Verfahrens zur Fehlerüberwachung eines Batteriepacks mit mehreren Batteriezellen.

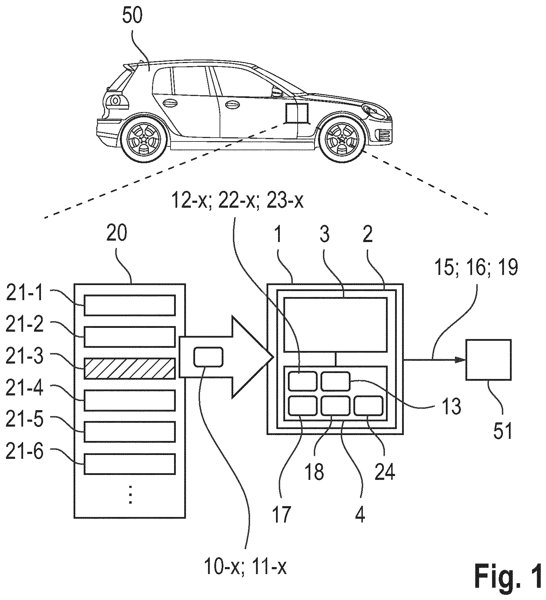

Die Fig. 1 zeigt eine schematische Darstellung einer Ausführungsform der Vorrichtung 1 zur Fehlerüberwachung eines Batteriepacks 20 mit mehreren Batteriezellen 21-x. Die Vorrichtung 1 und das Batteriepack 20 sind in einem Fahrzeug 50 angeordnet. Es kann vorgesehen sein, dass die Vorrichtung 1 in dem Batteriepack 20 angeordnet ist. Die Vorrichtung 1 ist dazu eingerichtet, das in dieser Offenbarung beschriebene Verfahren durchzuführen. Das Verfahren wird nachfolgend anhand der Vorrichtung 1 näher erläutert.

Die Vorrichtung 1 umfasst eine Datenverarbeitungseinrichtung 2. Die Datenverarbeitungseinrichtung 2 umfasst eine Recheneinrichtung 3 und einen Speicher 4. Die Datenverarbeitungseinrichtung 2 ist insbesondere dazu eingerichtet, zur Durchführung des in dieser Offenbarung beschriebenen Verfahrens notwendige Rechenoperationen durchzuführen.

Die Datenverarbeitungseinrichtung 2 ist dazu eingerichtet, Leerlaufspannungen 11-x umfassende Zustandsgrößen 10-x der Batteriezellen 21-x zu empfangen. Die Zustandsgrößen 10-x werden an den Batteriezellen 21-x insbesondere mittels hierfür eingerichteter Sensoren (nicht gezeigt) erfasst und/oder von einer Batteriesteuerung (nicht gezeigt) des Batteriepacks 20 bestimmt und bereitgestellt.

Anhand der empfangenen Leerlaufspannungen 11-x identifiziert die Datenverarbeitungseinrichtung 2 die Batteriezelle 21-x mit der kleinsten Leerlaufspannung 11-x als schwächste Batteriezelle 21-x. Ferner bestimmt die Datenverarbeitungseinrichtung 2 jeweils für jede der Batteriezellen 21-x mindestens eine Leistungsgröße 12-x des Batteriepacks 20 ausgehend von den empfangenen Zustandsgrößen 10-x der jeweiligen Batteriezelle 21-x.

Die mindestens eine Leistungsgröße 12-x des Batteriepacks 20, die ausgehend von den Zustandsgrößen 10-x der schwächsten Batteriezelle 21-x bestimmt wurde, wird mit einem von der Datenverarbeitungseinrichtung 2 gebildeten Mittelwert 13 der mindestens einen Leistungsgröße 12-x verglichen, der aus den Leistungsgrößen 12-x des Batteriepacks 20 bestimmt wurde, die ausgehend von den Zustandsgrößen 10-x der restlichen Batteriezellen 21-x bestimmt wurden. Die Datenverarbeitungseinrichtung 2 bestimmt einen Fehlerzustand 15 ausgehend von einem Vergleichsergebnis und stellt den Fehlerzustand 15 bereit, beispielsweise als analoges oder digitales Fehlerzustandssignal 16. Der Fehlerzustand 15 bzw. das Fehlerzustandssignal 16 kann beispielsweise einer Fahrzeugsteuerung 51 zugeführt werden. Der Fehlerzustand 15 umfasst insbesondere zumindest die folgenden möglichen Ausprägungen: "fehlerfrei" und "fehlerhaft".

Ist beispielsweise die Batteriezelle 21-3 die schwächste Batteriezelle 21-3 (in der Fig. 1 schraffiert dargestellt), so wird der Mittelwert 13 aus den anhand der Zustandsgrößen 10-1, 10-2, 10-4, 10-5, 10-6 der restlichen Batteriezellen 21-1, 21-2, 21-4, 21-5, 21-6 bestimmten Leistungsgrößen 12-1, 12-2, 12-4, 12-5, 12-6 bestimmt. Hierbei wird insbesondere für jede der Batteriezellen 21-x ausgehend von deren Zustandsgrößen 10-x die Leistungsgröße 12-x für das gesamte Batteriepack 20 bestimmt. Der bestimmte Mittelwert 13 wird dann mit der bestimmten Leistungsgröße 12-3, die ausgehend von den Zustandsgrößen 10-x der schwächsten Batteriezelle 21-3 bestimmt wurde, verglichen.

Es kann vorgesehen sein, dass im Rahmen des Vergleichs eine Differenz 17 zwischen der mindestens einen Leistungsgröße 12-x des Batteriepacks 20, die ausgehend von den Zustandsgrößen 10-x der schwächsten Batteriezelle 21-x bestimmt wurde, und dem bestimmten Mittelwert 13 bestimmt und mit mindestens einem vorgegebenen Fehlerschwellwert 18 verglichen wird, wobei der Fehlerzustand 15 geändert wird, wenn der mindestens eine vorgegebene Fehlerschwellwert 18 überschritten ist. Der Fehlerzustand 15 wird dann insbesondere von "fehlerfrei" zu "fehlerhaft" geändert. Der mindestens eine vorgegebene Fehlerschwellwert 18 kann beispielsweise ausgehend von empirischen Versuchsreihen und/oder durch Simulation bestimmt werden.

Weiterbildend kann vorgesehen sein, dass in Abhängigkeit von einem Überschreiten des mindestens einen Fehlerschwellwertes 18 mindestens eine jeweils dem Fehlerschwellwert 18 zugeordnete Aktion 19 ausgeführt und/oder veranlasst wird. Die Aktion 19 kann beispielsweise das Ausgeben eines Abschaltbefehls umfassen, der der Fahrzeugsteuerung 51 (oder direkt einer Batteriesteuerung des Batteriepacks 20) zugeführt wird und der die Abschaltung des Batteriepacks 20 bewirkt, beispielsweise, indem hierfür eingerichtete Schütze eine elektrische Verbindung zum Fahrzeugnetz trennen.

Es kann vorgesehen sein, dass die mindestens eine Leistungsgröße 12-x des Batteriepacks 20 einen SOE-Wert 22-x des Batteriepacks 20 umfasst. Eine beispielhafte Vorgehensweise zum Bestimmen des SOE-Wertes wurde bereits in der allgemeinen Beschreibung beschrieben.

Weiterbildend kann vorgesehen sein, dass der SOE-Wert 22-x jeweils ausgehend von einer bestimmten Restenergiemenge der Batteriezellen 21-x und einer Maximalenergiemenge der Batteriezellen bestimmt wird. Eine beispielhafte Vorgehensweise hierzu wurde bereits in der allgemeinen Beschreibung beschrieben.

Es kann vorgesehen sein, dass die mindestens eine Leistungsgröße 12-x des Batteriepacks 20 eine Restreichweite 23-x umfasst, wobei die Restreichweite 23-x ausgehend von einer jeweils bestimmten Restenergiemenge des Batteriepacks 20 und einem Verbrauchsparameter bestimmt wird. Eine beispielhafte Vorgehensweise zum Bestimmen der Restenergiemenge wurde bereits in der allgemeinen Beschreibung beschrieben.

Es kann vorgesehen sein, dass zusätzlich die bestimmten Leerlaufspannungen 11-x mit mindestens einem vorgegebenen Leerlaufspannungsschwellwert 24 verglichen werden, wobei der Fehlerzustand 15 zusätzlich auch unter Berücksichtigung von einem Vergleichsergebnis des Vergleichs der Leerlaufspannungen 11-x mit dem mindestens einen vorgegebenen Leerlaufspannungsschwellwert 24 bestimmt und bereitgestellt wird. Hierbei kann auch eine Gewichtung und/oder logische Verknüpfung der Vergleichsergebnisse erfolgen.

Es kann vorgesehen sein, dass ausgehend von einer zeitlichen Entwicklung der mindestens einen Leistungsgröße 12-x ein zukünftiger Wert der mindestens einen Leistungsgröße 12-x geschätzt wird und das Vergleichen für den geschätzten zukünftigen Wert durchgeführt wird. Hierzu extrapoliert die Datenverarbeitungseinrichtung 2 beispielsweise die mindestens eine Leistungsgröße 12-x anhand von Werten, die für die Vergangenheit bestimmt wurden.

Die nachfolgende Tabelle zeigt ein beispielhaftes Szenario für mehrere Batteriepacks mit jeweils 96 Zellen:

| nom. Zellspannung | Leerlaufspannung (V) | Anzahl Zellen | Nominelle Pack-Spannung (V) | Pack-Spannung (V) | SOC (%) | SOH | Kapazität (Ah) | SOE: kWh/Pack (nominelle Spannung | Verbrauch (km/kWh) | Restreichweite (km) |
|---|---|---|---|---|---|---|---|---|---|---|
| 3,7 | 4 | 96 | 355,2 | 384 | 90 | 1 | 78 | 44,92 | 100 km/ 15 kWh | 277,05 |
| 3,7 | 3,9 | 96 | 355,2 | 374,4 | 80 | 0,95 | 78 | 36,99 | 100 km/ 15 kWh | 233,95 |
| 3,7 | 3,7 | 96 | 355,2 | 384 | 50 | 1 | 78 | 23,08 | 100 km/ 15 kWh | 153,92 |
| 3,7 | 3,7 | 96 | 355,2 | 355,2 | 50 | 0,9 | 78 | 20,77 | 100 km/ 15 kWh | 138,52 |

Die Vorteile des Verfahrens lassen sich anhand der Werte der letzten beiden Zeilen der Tabelle verdeutlichen. Bei gleicher Leerlaufspannung ist der SOH-Wert in der letzten Zeile deutlich kleiner als in der dritten Zeile. Beurteilt man das Batteriepack in der letzten Zeile mit einem SOH-Wert von 0,9 bereits als kritisch, so kann bei alleiniger Überwachung der Leerlaufspannung, wie dies im Stand der Technik erfolgt, das kritische Batteriepack zwar identifiziert werden, jedoch würde allein anhand der Leerlaufspannung auch das unkritische Batteriepack in der dritten Zeile als kritisch beurteilt werden (und dies bei einem unkritischen SOH-Wert von 1). Hingegen kann mit dem SOE-Wert und/oder mit der Restreichweite als gemäß dem in dieser Offenbarung beschriebenen Verfahren bestimmte Leistungsgrößen eine deutlich feinere Unterscheidung getroffen werden, sodass "false positive"-Entscheidungen reduziert oder sogar vermieden werden können.

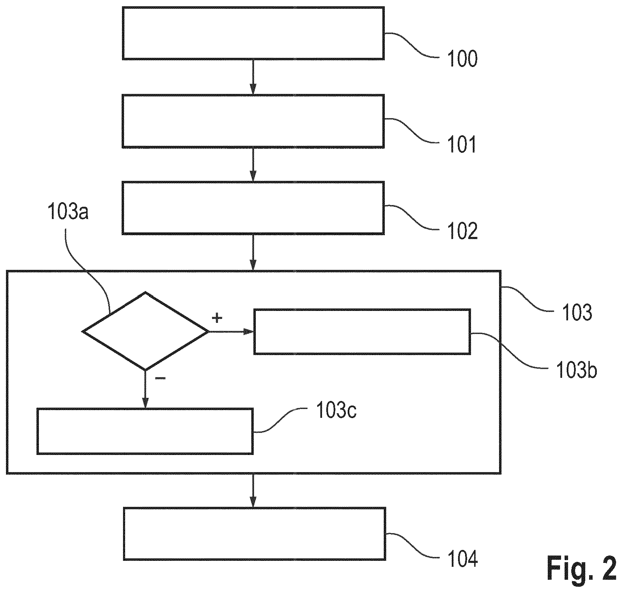

Die Fig. 2 zeigt ein schematisches Ablaufdiagramm einer Ausführungsform des Verfahrens zur Fehlerüberwachung eines Batteriepacks mit mehreren Batteriezellen. Das Verfahren wird insbesondere mittels einer Vorrichtung gemäß einer der voranstehend beschriebenen Ausführungsformen durchgeführt.

In einer Maßnahme 100 werden Leerlaufspannungen umfassende Zustandsgrößen der Batteriezellen bestimmt oder empfangen.

In einer Maßnahme 101 wird anhand der bestimmten oder empfangenen Leerlaufspannungen die Batteriezelle mit der kleinsten Leerlaufspannung als schwächste Batteriezelle identifiziert.

In einer Maßnahme 102 wird jeweils für jede der Batteriezellen mindestens eine Leistungsgröße des Batteriepacks ausgehend von den bestimmten oder empfangenen Zustandsgrößen der Batteriezelle bestimmt. Die Leistungsgrößen sind insbesondere ein SOE-Wert und/oder eine Restreichweite.

In einer Maßnahme 103 wird die mindestens eine Leistungsgröße des Batteriepacks, die ausgehend von den Zustandsgrößen der schwächsten Batteriezelle bestimmt wurde, mit einem Mittelwert der mindestens einen Leistungsgröße verglichen, der aus den Leistungsgrößen des Batteriepacks bestimmt wurde, die ausgehend von den Zustandsgrößen der restlichen Batteriezellen bestimmt wurden. Ferner wird ein Fehlerzustand ausgehend von einem Vergleichsergebnis bestimmt und bereitgestellt.

Die Maßnahme 103 umfasst Maßnahme 103a, in der im Rahmen des Vergleichs eine Differenz zwischen der mindestens einen Leistungsgröße des Batteriepacks, die ausgehend von den Zustandsgrößen der schwächsten Batteriezelle bestimmt wurde, und dem bestimmten Mittelwert bestimmt und mit einem vorgegebenen Fehlerschwellwert verglichen wird. Ergibt der Vergleich mit dem vorgegebenen Fehlerschwellwert, dass dieser überschritten ist, so wird in einer Maßnahme 103b ein Fehlerzustand auf "fehlerhaft" geändert. Ergibt der Vergleich hingegen, dass der Fehlerschwellwert nicht überschritten ist, so wird der Fehlerzustand in Maßnahme 103c auf "fehlerfrei" geändert bzw. der Fehlerzustand bleibt auf "fehlerfrei" gesetzt.

In einer Maßnahme 104 wird das Vergleichsergebnis ausgegeben. Insbesondere wird der bestimmte Fehlerzustand ausgegeben, beispielsweise als analoges oder digitales Fehlerzustandssignal.

Es ist insbesondere vorgesehen, dass das Verfahren wiederholt, insbesondere regelmäßig, durchgeführt wird.

Weitere Ausführungsformen des Verfahrens wurden bereits mit Bezug auf die Vorrichtung erläutert.

Bezugszeichenliste

1        Vorrichtung
2        Datenverarbeitungseinrichtung

| 3 | Recheneinrichtung |
|---|---|
| 4 | Speicher |
| 10-x | Zustandsgröße |
| 11-x | Leerlaufspannung |
| 12-x | Leistungsgröße |
| 13 | Mittelwert |
| 15 | Fehlerzustand |
| 16 | Fehlerzustandssignal |
| 17 | Differenz |
| 18 | Fehlerschwellwert |
| 19 | Aktion |
| 20 | Batteriepack |
| 21-x | Batteriezelle |
| 22-x | SOE-Wert |
| 23-x | Restreichweite |
| 24 | Leerlaufspannungsschwellwert |
| 50 | Fahrzeug |
| 51 | Fahrzeugsteuerung |
| 100-104 | Maßnahmen des Verfahrens |

**Patentansprüche**

1. Verfahren zur Fehlerüberwachung eines Batteriepacks (20) mit mehreren Batteriezellen (21-x),

   wobei Leerlaufspannungen (11-x) umfassende Zustandsgrößen (10-x) der Batteriezellen (21-x) bestimmt oder empfangen werden,
   wobei anhand der bestimmten oder empfangenen Leerlaufspannungen (11-x) die Batteriezelle (21-x) mit der kleinsten Leerlaufspannung (11-x) als schwächste Batteriezelle (21-x) identifiziert wird, und
   wobei jeweils für jede der Batteriezellen (21-x) mindestens eine Leistungsgröße (12-x) des Batteriepacks (20) ausgehend von den bestimmten oder empfangenen Zustandsgrößen (10-x) der Batteriezelle (21-x) bestimmt wird,
   und wobei die mindestens eine Leistungsgröße (12-x) des Batteriepacks (20), die ausgehend von den Zustandsgrößen (10-x) der schwächsten Batteriezelle (21-x) bestimmt wurde, mit einem Mittelwert (13) der mindestens einen Leistungsgröße (12-x) verglichen wird, der aus den Leistungsgrößen (12-x) des Batteriepacks (20) bestimmt wurde, die ausgehend von den Zustandsgrößen (10-x) der restlichen Batteriezellen (21-x) bestimmt wurden, und
   wobei ein Fehlerzustand (15) ausgehend von einem Vergleichsergebnis bestimmt und bereitgestellt wird.

2. Verfahren nach Anspruch 1, **dadurch gekennzeichnet, dass**
   im Rahmen des Vergleichs eine Differenz (17) zwischen der mindestens einen Leistungsgröße (12-x) des Batteriepacks (20), die ausgehend von den Zustandsgrößen (10-x) der schwächsten Batteriezelle (21-x) bestimmt wurde, und dem bestimmten Mittelwert (13) bestimmt und mit mindestens einem vorgegebenen Fehlerschwellwert (18) verglichen wird, und wobei der Fehlerzustand geändert wird, wenn der mindestens eine vorgegebene Fehlerschwellwert (18) überschritten ist.

3. Verfahren nach Anspruch 2, **dadurch gekennzeichnet, dass** in Abhängigkeit von einem Überschreiten des mindestens einen Fehlerschwellwertes (18) mindestens eine jeweils dem Fehlerschwellwert (18) zugeordnete Aktion (19) ausgeführt und/oder veranlasst wird.

4. Verfahren nach einem der vorangegangenen Ansprüche, **dadurch gekennzeichnet, dass** die mindestens eine Leistungsgröße (12-x) des Batteriepacks (20) einen SOE-Wert (22-x) des Batteriepacks (20) umfasst.

5. Verfahren nach Anspruch 4, **dadurch gekennzeichnet, dass** der SOE-Wert (22-x) jeweils ausgehend von einer bestimmten Restenergiemenge der Batteriezellen (21-x) und einer Maximalenergiemenge der Batteriezellen (21-x) bestimmt wird.

6. Verfahren nach einem der vorangegangenen Ansprüche, **dadurch gekennzeichnet, dass** die mindestens eine Leistungsgröße (12-x) des Batteriepacks (20) eine Restreichweite (23-x) umfasst, wobei die Restreichweite (23-x)

ausgehend von einer jeweils bestimmten Restenergiemenge des Batteriepacks (20) und einem Verbrauchsparameter bestimmt wird.

7. Verfahren nach einem der vorangegangenen Ansprüche, **dadurch gekennzeichnet, dass** zusätzlich die bestimmten Leerlaufspannungen (11-x) mit mindestens einem vorgegebenen Leerlaufspannungsschwellwert (24) verglichen werden, wobei der Fehlerzustand zusätzlich auch unter Berücksichtigung von einem Vergleichsergebnis des Vergleichs der Leerlaufspannungen (11-x) mit dem mindestens einen vorgegebenen Leerlaufspannungsschwellwert (24) bestimmt und bereitgestellt wird.

8. Vorrichtung (1) zur Fehlerüberwachung eines Batteriepacks (20) mit mehreren Batteriezellen (21-x), umfassend:

eine Datenverarbeitungseinrichtung (2), wobei die Datenverarbeitungseinrichtung (2) dazu eingerichtet ist, Leerlaufspannungen (11-x) umfassende Zustandsgrößen (10-x) der Batteriezellen (21-x) zu empfangen, anhand der empfangenen Leerlaufspannungen (11-x) die Batteriezelle (21-x) mit der kleinsten Leerlaufspannung (11-x) als schwächste Batteriezelle (21-x) zu identifizieren, und
jeweils für jede der Batteriezellen (21-x) mindestens eine Leistungsgröße (12-x) des Batteriepacks (20) ausgehend von den empfangenen Zustandsgrößen (10-x) der Batteriezelle (21-x) zu bestimmen,
die mindestens eine Leistungsgröße (12-x) des Batteriepacks (20), die ausgehend von den Zustandsgrößen (10-x) der schwächsten Batteriezelle (21-x) bestimmt wurde, mit einem Mittelwert (13) der mindestens einen Leistungsgröße (12-x) zu vergleichen, der aus den Leistungsgrößen (12-x) des Batteriepacks (20) bestimmt wurde, die ausgehend von den Zustandsgrößen (10-x) der restlichen Batteriezellen (21-x) bestimmt wurden, und einen Fehlerzustand ausgehend von einem Vergleichsergebnis zu bestimmen und bereitzustellen.

9. Batteriepack (20), umfassend mindestens eine Vorrichtung (1) nach Anspruch 8.

10. Fahrzeug (50), umfassend mindestens eine Vorrichtung (1) nach Anspruch 8 und/oder mindestens ein Batteriepack (20) nach Anspruch 9.

**Claims**

1. Method for monitoring faults in a battery pack (20) having a plurality of battery cells (21-x),

wherein state variables (10-x) of the battery cells (21-x) comprising open-circuit voltages (11-x) are determined or received,
wherein, on the basis of the determined or received open-circuit voltages (11-x), the battery cell (21-x) having the smallest open-circuit voltage (11-x) is identified as the weakest battery cell (21-x), and
wherein, for each of the battery cells (21-x), at least one power variable (12-x) of the battery pack (20) is determined on the basis the determined or received state variables (10-x) of the battery cell (21-x),
and wherein the at least one power variable (12-x) of the battery pack (20), which was determined on the basis of the state variables (10-x) of the weakest battery cell (21-x), is compared with a mean value (13) of the at least one power variable (12-x) which was determined from the power variables (12-x) of the battery pack (20), which were determined on the basis of the state variables (10-x) of the remaining battery cells (21-x), and
wherein a fault state (15) is determined and provided on the basis of a comparison result.

2. Method according to claim 1, **characterized in that,** as part of the comparison, a difference (17) between the at least one power variable (12-x) of the battery pack (20), which was determined on the basis of the state variables (10-x) of the weakest battery cell (21-x), and the determined mean value (13) is determined and compared with at least one predetermined fault threshold value (18), and the fault state being changed if the at least one predetermined fault threshold value (18) is exceeded.

3. Method according to claim 2, **characterized in that,** depending on whether the at least one fault threshold value (18) is exceeded, at least one action (19) associated with the fault threshold value (18) is executed and/or initiated.

4. Method according to any of the preceding claims, **characterized in that** the at least one power variable (12-x) of the battery pack (20) comprises an SOE value (22-x) of the battery pack (20).

5. Method according to claim 4, **characterized in that** the SOE value (22-x) is determined on the basis of a determined remaining amount of energy of the battery cells (21-x) and a maximum amount of energy of the battery cells (21-x).

6. Method according to any of the preceding claims, **characterized in that** the at least one power variable (12-x) of the battery pack (20) comprises a remaining range (23-x), the remaining range (23-x) being determined on the basis of a determined remaining amount of energy of the battery pack (20) and a consumption parameter.

7. Method according to any of the preceding claims, **characterized in that** additionally, the determined open-circuit voltages (11-x) are compared with at least one predetermined open-circuit voltage threshold value (24), the fault state additionally being determined and provided taking into account a comparison result from the comparison of the open-circuit voltages (11-x) with the at least one predetermined open-circuit voltage threshold value (24).

8. Device (1) for monitoring faults in a battery pack (20) having a plurality of battery cells (21-x), the device comprising:

a data processing apparatus (2), wherein the data processing apparatus (2) is configured to receive state variables (10-x) of the battery cells (21-x) comprising open-circuit voltages (11-x), to identify, on the basis of the received open-circuit voltages (11-x), the battery cell (21-x) having the smallest open-circuit voltage (11-x) as the weakest battery cell (21-x), and
to determine, for each of the battery cells (21-x), at least one power variable (12-x) of the battery pack (20) on the basis of the received state variables (10-x) of the battery cell (21-x),
to compare the at least one power variable (12-x) of the battery pack (20), which was determined on the basis of the state variables (10-x) of the weakest battery cell (21-x), with a mean value (13) of the at least one power variable (12-x) which was determined from the power variables (12-x) of the battery pack (20), which were determined on the basis of the state variables (10-x) of the remaining battery cells (21-x), and
to determine and provide a fault state on the basis of a comparison result.

9. Battery pack (20), comprising at least one device (1) according to claim 8.

10. Vehicle (50), comprising at least one device (1) according to claim 8 and/or at least one battery pack (20) according to claim 9.

## Revendications

1. Procédé de surveillance de défaut d'un bloc-batterie (20) comportant plusieurs éléments de batteries (21-x),

dans lequel des variables d'état (10-x) des éléments de batterie (21-x) comprenant des tensions à vide (11-x) sont déterminées ou reçues,
dans lequel, à l'aide des tensions à vide (11-x) déterminées ou reçues, l'élément de batterie (21-x) comportant la plus petite tension à vide (11-x) est identifié comme étant l'élément de batterie (21-x) le plus faible, et
dans lequel au moins une variable de puissance (12-x) du bloc-batterie (20) est déterminée respectivement pour chacun des éléments de batterie (21-x) à partir des variables d'état (10-x) déterminées ou reçues de l'élément de batterie (21-x),
et dans lequel l'au moins une variable de puissance (12-x) du bloc-batterie (20), qui a été déterminée à partir des variables d'état (10-x) de l'élément de batterie (21-x) le plus faible, est comparée à une valeur moyenne (13) de l'au moins une variable de puissance (12-x), qui a été déterminée à partir des variables de puissance (12-x) du bloc-batterie (20), qui ont été déterminées à partir des variables d'état (10-x) des éléments de batterie (21-x) restants, et
dans lequel un état de défaut (15) est déterminé et mis à disposition à partir d'un résultat de comparaison.

2. Procédé selon la revendication 1, **caractérisé en ce que** dans le cadre de la comparaison, une différence (17) entre l'au moins une variable de puissance (12-x) du bloc-batterie (20), qui a été déterminée à partir des variables d'état (10-x) de l'élément de batterie (21-x) le plus faible, et la valeur moyenne (13) déterminée est déterminée et comparée à au moins une valeur seuil de défaut (18) prédéfinie, et dans lequel l'état de défaut est modifié lorsque l'au moins une valeur seuil de défaut (18) prédéfinie est dépassée.

3. Procédé selon la revendication 2, **caractérisé en ce qu'**en fonction d'un dépassement de l'au moins une valeur seuil de défaut (18), au moins une action (19) associée respectivement à la valeur seuil de défaut (18) est exécutée et/ou déclenchée.

4. Procédé selon l'une des revendications précédentes, **caractérisé en ce que** l'au moins une variable de puissance (12-x) du bloc-batterie (20) comprend une valeur SOE (22-x) du bloc-batterie (20).

5. Procédé selon la revendication 4, **caractérisé en ce que** la valeur SOE (22-x) est déterminée respectivement à partir d'une quantité d'énergie résiduelle déterminée des éléments de batterie (21-x) et d'une quantité d'énergie maximale des éléments de batterie (21-x).

6. Procédé selon l'une des revendications précédentes, **caractérisé en ce que** l'au moins une variable de puissance (12-x) du bloc-batterie (20) comprend une autonomie résiduelle (23-x), dans lequel l'autonomie résiduelle (23-x) est déterminée à partir d'une quantité d'énergie résiduelle du bloc-batterie (20) respectivement déterminée et d'un paramètre de consommation.

7. Procédé selon l'une des revendications précédentes, **caractérisé en ce que,** en outre, les tensions à vide (11-x) déterminées sont comparées à au moins une valeur seuil de tension à vide (24) prédéfinie, dans lequel l'état de défaut est en outre également déterminé et mis à disposition en tenant compte d'un résultat de comparaison de la comparaison des tensions à vide (11-x) à l'au moins une valeur seuil de tension à vide (24) prédéfinie.

8. Dispositif (1) de surveillance de défaut d'un bloc-batterie (20) comportant plusieurs éléments de batterie (21-x), comprenant :

   un dispositif de traitement de données (2), dans lequel le dispositif de traitement de données (2) est conçu pour recevoir des variables d'état (10-x) des éléments de batterie (21-x) comprenant des tensions à vide (11-x), pour identifier, à l'aide des tensions à vide (11-x) reçues, l'élément de batterie (21-x) comportant la plus petite tension à vide (11-x) comme étant l'élément de batterie (21-x) le plus faible, et
   pour déterminer respectivement pour chacun des éléments de batterie (21-x) au moins une variable de puissance (12-x) du bloc-batterie (20) à partir des variables d'état (10-x) de l'élément de batterie (21-x) reçues,
   pour comparer l'au moins une variable de puissance (12-x) du bloc-batterie (20), qui a été déterminée à partir des variables d'état (10-x) de l'élément de batterie (21-x) le plus faible, à une valeur moyenne (13) de l'au moins une variable de puissance (12-x), qui a été déterminée à partir des variables de puissance (12-x) du bloc-batterie (20), qui ont été déterminées à partir des variables d'état (10-x) des éléments de batterie (21-x) restants, et
   pour déterminer et mettre à disposition un état de défaut à partir d'un résultat de comparaison.

9. Bloc-batterie (20), comprenant au moins un dispositif (1) selon la revendication 8.

10. Véhicule (50) comprenant au moins un dispositif (1) selon la revendication 8 et/ou au moins un bloc-batterie (20) selon la revendication 9.

**Fig. 1**

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 106707180 A
- US 20200249279 A1
- US 20200408849 A1
- DE 102020130547 A1
- US 20140278167 A1